# EUROPÄISCHE PATENTSCHRIFT

(11) **EP 1 718 983 B1**
(45) Veröffentlichungstag und Bekanntmachung des Hinweises auf die Patenterteilung: **09.07.2008**
(21) Anmeldenummer: 05716759.5
(22) Anmeldetag: 21.02.2005
(51) Int. Cl.: G01R 31/34, G01R 19/25, G01R 31/40, G01R 31/42

(54) **ERKENNUNGSVERFAHREN F R EINE ELEKTRISCHE MEHRPHASENMASCHINE**
DETECTION METHOD FOR AN ELECTRICAL POLYPHASE MACHINE
PROCEDE DE RECONNAISSANCE POUR MACHINE ELECTRIQUE POLYPHASEE

(30) Priorität: 24.02.2004 DE 102004008885
(43) Veröffentlichungstag der Anmeldung: 08.11.2006
(73) Patentinhaber: Lenze Drive Systems GmbH, 31855 Aerzen (DE)
(72) Erfinder: EHLICH, Martin, 32689 Kalletal (DE); TINEBOR, Manfred, 32683 Barntrup (DE); MUELLER, Mario, Lenze Drive Systems GmbH, 31855 Aerzen (DE); SOMMER, Marc, Lenze Drive Systems GmbH, 31855 Aerzen (DE); EUTEBACH, Thomas, Lenze Drive Systems GmbH, 31855 Aerzen (DE)
(74) Vertreter: Leonhard, Frank Reimund
(86) Internationale Anmeldenummer: PCT/EP2005/050748
(87) Internationale Veröffentlichungsnummer: WO 2005/081005

(56) Entgegenhaltungen:
- DE-A1- 19 709 596
- US-A- 4 777 446
- US-A1- 2002 158 658
- N.N.: "Der Mehrphasen Induktionsmotor"[Online] 25. Oktober 1997 (1997-10-25), Seiten 1-1, XP002331532 Gefunden im Internet: URL:http://www.ebe-online.de/Home/tgobmaie /Tesla/polyphase.htm> [gefunden am 2005-06-13]

## Beschreibung

Die Erfindung befasst sich mit einem Verfahren zur Erkennung einer an einen Umrichter angeschlossenen Mehrphasenmaschine (Motor oder Generator) mit einem Stator und einem Rotor sowie "elektrischen Phasen" als Wicklungen. Eine so arbeitende Einrichtung ist ebenfalls erfasst.

Die DE-A1 197 09 596 (Temic) beschreibt ein Verfahren zum Identifizieren eines elektrischen Motors für Wechselstrom, der als Induktionsmotor ausgebildet ist, aus einer Baureihe von Motoren.

Moderne Umrichter, welche mehrphasige elektrische Aggregate (Maschinen) ansteuern, wie Synchronmaschinen oder Asynchronmaschinen, sind von Hause aus umschaltbar. Sie sind nicht fest auf einen Maschinentyp ausgerichtet, sondern enthalten Programmsegmente und Steuerfunktionen für mehrere Maschinentypen, beispielsweise die genannten Synchronmaschinen oder Asynchronmaschinen, oder auch andere Mehrphasenmaschinen, wie Reluktanzmaschinen oder synchronähnliche Maschinen oder Servoantriebe. Sinnvoller Weise erfolgt eine Steuerung und Regelung der unterschiedlichen Maschinentypen mit nicht gleichen Steuerfunktionen, Regelfunktionen und auch nicht gleichen Parametern. Auch eventuelle Überwachungsfunktionen müssen nicht zwingend gleich für die unterschiedlichen Maschinentypen sein.

Bei der Inbetriebnahme ist daher die Kenntnis des angeschlossenen Typs von Maschine erforderlich, der vom Inbetriebnehmer dem Umrichter vorgegeben wird, bevor er mit übrigen Parametern an das Antriebsumfeld (bei Motoren) und die eigentliche Maschine weiter angepasst wird.

Der Person, welche die Inbetriebnahme vornimmt, ist die Kenntnis des Maschinentyps aber nicht immer zuzurechnen. Er muss sich aufgrund von Kontrolllisten, Typenlisten und anderen Informationen Sicherheit darüber verschaffen, welcher Maschinentyp aktuell in Betrieb zu nehmen ist. Das ist umso mehr erschwert, als Servomotoren hinsichtlich ihrer Bauform nicht einfach von außen zu unterscheiden sind, ob sie vom Typ Synchronmaschine oder vom Typ Asynchronmaschine sind. Optisch sind diese Servoantriebe von außen kaum unterscheidbar; meist hilft ein Typenschild, das aber auch nicht immer in Klarschrift Auskunft über den Typ der Maschine gibt, vielmehr andere Daten zum Umfeld des Antriebs nennt, wie Spannungen, Leistungen oder Anschlussbelegung der elektrischen Phasen.

Die Erfindung geht deshalb von der Aufgabe aus, eine Inbetriebnahme zu vereinfachen, sicherer zu gestalten und auch zu verkürzen, ohne dass dem die Inbetriebnahme Ausführenden Listen oder Zahlenkolonnen mitgegeben werden müssen, um Motortypen erkennen zu können. Mit anderen Worten soll die Person von dem Problem entlastet werden, den Maschinentyp eigenständig festzustellen oder dem Umrichter nach seiner eigenen, persönlichen Kenntnis vorzugeben. Das System soll sich insoweit selbst auf den angeschlossenen Typ von Aggregat (=Maschine) einstellen können.

Dazu erhält der Umrichter Funktionen, die es ihm erlauben, selbst den Typ der angeschlossenen Maschine zu erkennen (Anspruch 1, Anspruch 30, Anspruch 41). Davon betroffen ist auch die Steuerung, welche Programmsegmente enthält, die diese Auswahl ermöglichen. Ebenso wird diese Aufgabe durch eine Einrichtung gelöst (Anspruch 40), welche die umschriebenen Verfahrensschritte ausführen kann, soweit sie nicht darin bestehen, dass Leitungsanschlüsse des Motors oder Generators und des Umrichters angeschlossen werden müssen.

Die Funktionen ermöglichen eine selbsttätige Erkennung, ohne Eingabe von Typen. Z.B. erfolgt diese Erkennung dadurch, dass ein Widerstands- oder Impedanzverlauf über den Statorwinkel durch eine geeignete Stimulation identifiziert wird (Anspruch 10, 11, 16). Eine zumindest einmalige Wiederholung ist für zumindest ein weiteres Testsignal vorgesehen (Anspruch 1, Anspruch 27). Es ergibt sich daraus zumindest ein weiterer Messwert, der Bestandteil der Vergleichsfunktion wird, die nach Merkmal (g) mit zumindest einer von mehreren Referenzfunktionen verglichen wird.

Die Wiederholung betrifft die Schritte (b) bis (d), und kann auch eine mehrfache Wiederholung sein, zur Bildung (Ergänzung und Erweiterung) der Vergleichsfunktion (Anspruch 7, Anspruch 2). Dieser Zeitabschnitt kann auch "Erkennungsphase" genannt werden, gegebenenfalls erweitert um den Schritt des Vergleichs (Merkmal (g)), und während dieser Phase kann die Maschine bereits über die Welle mit der Abtriebsseite starr gekoppelt sein (Anspruch 70). Ist eine solche Kopplung vorgesehen, wird die Maschine sich während der Erkennungsphase nicht drehen (Anspruch 71).

Über die Art der Testsignale bei Wiederholung gibt es unterschiedliche Formen (Anspruch 7). Die Testsignale können gleich sein, dann aber bei unterschiedlichen elektrischen Phasen und/oder bei unterschiedlichen elektrischen Winkellagen des Statorfeldes (Anspruch 72, 73). Es sind dabei Testsignale in Verbindung mit Winkellagen zu vermeiden, die redundante Informationen liefern. Redundante Messungen können aber auch zusammengefasst werden, um sie zu einem Mittelwert werden zu lassen, der an einer bestimmten Winkellage mit ein und demselben Testsignal mehrfach einen ersten Messwert ergibt, wobei dieser erste Messwert sich als erster gemittelter Messwert aus mehreren Messwerten zusammensetzt.

Die Identifizierung, des Impedanzverlaufs über dem Winkel erfolgt für die angeschlossene Maschine. Ist die Impedanz über dem Winkel annähernd konstant, kann auf bspw. eine Asynchronmaschine geschlossen werden (Anspruch 5, 12, 13 und 15). Weist der Impedanzverlauf zumindest einen eindeutigen Hochpunkt und Tiefpunkt (Minimum und Maximum) auf, kann auf eine beispielsweise permanent erregte Synchronmaschine geschlossen werden (Anspruch 6, 7, 14).

Die Möglichkeit der Erkennung durch den Umrichter selbst erfolgt im Rahmen seines Steuerteils (Anspruch 8, Anspruch 40), welcher die Ansteuerroutinen für den Umrichter freigeschaltet oder eingestellt erhält, abhängig von dem Erkennungsergebnis, das von einer Identifikation eigenständig vorgenommen wird, ohne Einfluss der die Maschine in Betrieb nehmenden Person.

Unter einem Umrichter soll dabei jedwede Art von Leistungseinrichtung verstanden werden, welche Leistungs-Stellsignale abzugeben in der Lage ist, zur Ansteuerung der genannten Mehrphasenmaschine (Anspruch 9). Dabei ist davon auszugehen, dass verschiedene Arten von Umrichtern (Wechselrichter, gesteuerte Gleichrichter, Frequenzumrichter, Frequenzumformer und andere Typen) unter dem Begriff eines "Umrichters" hier zusammengefasst erwähnt werden sollen. Der Umrichter wird aus einem Netz gespeist, das ebenfalls Wechselspannung besitzen kann, aber nicht zwingend haben muss. Auch eine Speisung aus einem Gleichspannungskreis ist möglich, welch letzterer auch als Zwischenkreis zwischen zwei unterschiedlichen Wechselspannungskreisen vorgesehen sein kann, nicht zwingend nur Bestandteil eines einzigen Umrichters, sondern einer ganzen Gruppe von Umrichtern, welche denselben Zwischenkreis verwenden (Anspruch 9).

Nach einem Anschließen der elektrischen Phasen des mehrphasigen Motors oder Generators an die elektrischen Phasen (Ausgänge) des Umrichters wird vor einem Beginn eines Produktivbetriebs, also bei der Inbetriebnahme, ein Aufschalten eines ersten Testsignals erfolgen. Das Testsignal wird über die Anschlussleitungen zwischen Umrichter und Mehrphasenmaschine übertragen und hat zumindest eine Folge. Diese ursächliche Folge, beispielsweise eine Veränderung des Stroms, der Spannung oder anderer physikalischer Größen der Mehrphasenmaschine, wird über eine zugehörige Messeinrichtung erfasst. Das erfasste (erste) Messergebnis wird ausgewertet und dabei als Messwert einer Vergleichsfunktion zugeordnet.

Eine Vielzahl von nacheinander aufgenommenen Messergebnissen ergibt eine Vielzahl von Messpunkten der zu bildenden. Vergleichsfunktion (Ansprüche 17, 27, 28, 25 und 26). Die aus ausgewerteten Messergebnissen sich ergebende Vergleichsfunktion wird mit einer Referenzfunktion verglichen.

Es können mehrere Referenzfunktionen zum Vergleich bereitstehen, entsprechend der Anzahl der erkennbaren Typen von elektrisch betreibbaren Mehrphasenmaschinen (Anspruch 3). Ein Umrichter kann so viele Referenzfunktionen haben, wie er in der Lage ist, an typenorientierten Steuerprogrammen oder Regelprogrammen oder Überwachungsprogrammen zu bedienen. Eine jede der Referenzfunktionen steht für einen Typ von Mehrphasenmaschine, so dass die Auswahl der ähnlichsten Referenzfunktion im Vergleich zur über die Messergebnisse ermittelten Vergleichsfunktion gleichzeitig festlegt, welcher Maschinentyp der wahrscheinlichste ist (Anspruch 4).

Es mag bereits genügen, mit nur einer der mehreren Referenzfunktionen zu vergleichen, wenn mit diesem ersten Vergleich der passende Maschinentyp ermittelt werden kann (Anspruch 1). Es können aber auch mehrere Vergleiche durchgeführt werden und die Ähnlichkeitsergebnisse der Vergleiche miteinander verglichen werden, um die ähnlichste Referenzfunktion zu ermitteln, die dann für den wahrscheinlichsten Maschinentyp steht (Anspruch 3).

"Ausgehend von der so vorgenommenen Typidentifikation wird eines von mehreren zur Verfügung stehenden Systemprogrammen für den Produktivbetrieb ausgewählt und vorgegeben. Unter diesen Programmen können solche Programmsegmente oder Programmteile sein, wie Regelteil, Steuerteil oder Überwachungsteil (Anspruch 18). Ist ein Asynchronmotor erkannt worden, wird das Regelprogrammteil für den Asynchronmotor geladen, das zugehörige Steuerprogrammteil für den Umrichter und die auf Asynchronmaschinen speziell ausgerichteten Überwachungsprogramme. Statt einer direkten Auswahl aus einem lokalen Speicher, können diese Programme auch über Datenverbindungen zur Verfügung stehen, über-welche sie abgerufen und dem Umrichter zum Betrieb vorgegeben werden.

Durch diese Vorgaben ist der Umrichter (mit Steuerteil) an die angeschlossene Mehrphasenmaschine angepasst, ohne dass die Person, welche die Inbetriebnahme durchführt, diesbezüglich eine Auswahl vornehmen musste.

Die aus dem Testbetrieb - vor dem aktiven Produktivbetrieb - ermittelte Vergleichsfunktion wird mit mindestens einer Referenzfunktion verglichen. Ein solcher Vergleich kann auf viele Arten vorgenommen werden, nicht zwingend durch einen optischen Vergleich, der sich aber für Darstellungszwecke gut eignet. Ein Vergleich kann beispielsweise durch eine Korrelation der zu vergleichenden Funktionen vorgenommen werden. Es kann auch ein Punkt-zu-Punkt-Vergleich oder andere Vergleichsfunktionen der Statistik eingesetzt werden. "Vergleich" steht also symbolisch für die Ermittlung der Ähnlichkeit von Vergleichs- und Referenzfunktion (Anspruch 1).

An dem Messergebnis, das bevorzugt ein Widerstand oder eine Impedanz ist, und in Folge der mehreren Messungen und der mehreren Testsignale einen Widerstands- oder Impedanzverlauf ergibt, sind alle Ströme und alle Spannungen der Mehrphasenmaschine beteiligt (Anspruch 2, 27, 28). Deshalb kann auch von mehreren mehrphasigen oder Mehrphasen-Testsignalen gesprochen werden (Anspruch 22). An die elektrischen Phasen wird ein mehrphasiges Testsignal angelegt, welches gemeinsam das genannte Testsignal verursacht (Anspruch 2). Die vom Testsignal ausgehenden ursächlichen Folgen können Änderungen im Strom oder der Spannung an einem jeweiligen Statorwinkel sein, oder Änderungen der Drehzahl oder LageÄnderungen sein (Anspruch 19). Die Veränderungen werden gemessen und dann ausgewertet, zur punktweisen Bildung der genannten Vergleichsfunktion.

Der Charakter des Testsignals kann statistischer Natur sein (Anspruch 20), es kann ebenfalls ein Impulssignal oder ein Wechselsignal vorgesehen sein, welches als stationäres Wechselsignal oder als kurzzeitiges Wechselsignal Einfluss nimmt (Anspruch 20), beispielsweise nur so lange, wie eine bestimmte physische Drehlage des Rotors praktisch unverändert bleibt (Anspruch 21, oder Anspruch 35, 39, 30).

Entsteht die Vergleichsfunktion aus einer Mehrzahl von Messwerten (Anspruch 27,28,29, Anspruch 31,32), ist die Mehrzahl von Winkellagen bezogen auf den nicht drehenden Stator oder das sich nicht drehende Statorfeld die gemeinsame Größe, über welcher der Verlauf der physikalischen, von der Messung beeinflussten Größe gespeichert, aufgetragen oder dargestellt wird. Eine solche Darstellung oder Abbildung erfolgt hier symbolisch zur Veranschaulichung der Arbeitsweise, wird aber im Verfahrensablauf nicht nur in der hier veranschaulichend dargestellten Weise abgebildet- sondern zu Erkennungszwecken gespeichert. Dieser Werteverlauf wird in einem Speicherbereich abgespeichert, sowohl hinsichtlich der zumindest einen Referenzfunktion, wie auch hinsichtlich der Vergleichsfunktion und dann mit dem beschriebenen Vergleich miteinander lagerichtig verglichen.

Eine kontinuierliche Veränderung der Lage (Drehlage) des drehbaren Rotors der Mehrphasenmaschine sollte nicht erfolgen (Anspruch 35), kann aber auch so langsam erfolgen, dass dieser Bewegung überlagerte Testsignale mit einer höheren Frequenz noch immer an quasi stationären Lagepunkten oder Drehlagen im Statorsystem einen repräsentativen Messwert ursächlich zur Folge haben können. Mögliche Bewegungsfrequenz des Rotors und Testsignalfrequenzen sind dabei deutlich unterschiedlich (Anspruch 21, 23).

Ein Vorteil der beanspruchten Erfindung (Anspruch 16, 70) liegt in der Fähigkeit, die Maschine bereits an die abtriebsseitige Mechanik (über die Welle) angekoppelt zu haben oder zu lassen und dabei die Erkennungsphase ablaufen zu lassen. Dabei entsteht möglichst keine Drehbewegung der Welle. Diese wird erst zugelassen, nachdem die Erkennungsphase abgeschlossen und der Motortyp erkannt ist, in welcher Situation der Umrichter auf die Rotationsbewegung der Maschine eingestellt wurde. Dies ermöglicht die Typerkennung der Maschine auch nach einer Inbetriebnahme und zwischen Produktivbetrieben, sollte der Umrichter einmal initialisiert oder ausgetauscht worden sein und dabei den zuvor programmierten Maschinentyp als Speicherung verloren haben.

Das zur Stimulation verwendete Testsignal ist so beschrieben, dass es an den Maschinenklemmen anliegt. Es hat vorgelagert in seiner Entstehung des Blockschaltbildes, bzw. der Schaltungstechnik auch andere Vorläufer als Testsignal, die nicht zwingend ebenso ansehen müssen, insbesondere nicht bei einer feldorientierten Steuerung oder Regelung. Hier kann eine Modulation der d-Komponente in dem feld- oder fluss-orientierten System (d-q Transformation und Orientierung) vorgegeben werden, welche sich dann auf alle Phasen der Mehrphasenmaschine nach dem Umrichter auswirkt (Anspruch 2). Ebenso kann der sich aus der - an der Maschine gemessenen - ursächlichen Folge ergebende physikalische Messwert (Anspruch 17), wie beispielsweise Impedanz, auch auf unterschiedlichen Ebenen des Signalflussplans ergeben. So kann im feldorientierten System ein Stromvektor ermittelt werden und eine Impedanz auf dieser symbolischen Ebene berechnet werden.

Soweit zuvor also von Widerstand oder Impedanz als Auswertung der Messergebnisse gesprochen war, wie auch von Testsignalen, müssen diese nicht zwingend nur auf einer bestimmten Ebene des Signalflussplans verstanden werden. Lediglich die physikalische Messung der ursächlichen Folgen erfolgt elektrisch nahe der Mehrphasenmaschine, was räumlich aber durchaus entfernt sein kann, wenn die Messung im Umrichter vorgenommen wird und die Ursache des Stroms oder der Spannung über längere Leitungen zur Mehrphasenmaschine übertragen wird. Zumeist geht man von einem Dreiphasensystem aus, bei Drehstrom und bei elektrischen Phasen einer Maschine, bevorzugt eines Antriebs als Synchronmotor oder Asynchronmotor (Anspruch 33, Anspruch 34).

Nachdem auch mehrere Pole in einer Maschine vorhanden sein können, bezieht sich die Erläuterung auf eine "elektrische Maschine", die im mechanischen System mehrfach am Umfang verteilt sein kann, bei einer höheren Polpaarzahl (Anspruch 37).

Bei im einfachsten Fall angenommener zweipoliger Maschine (p=2) entspricht die elektrische Maschine der mechanischen Maschine, welche in den Figuren als Beispiel dargestellt ist. Auf eine höhere Polpaarzahl ist das entsprechend zu übertragen.

Die Vergleichsfunktion ist der angeschlossenen Maschine zugeordnet und wird über die Testsignale ermittelt; Referenzfunktionen sind Typen von Maschinen zugeordnet, so dass ein Vergleich ergeben kann, welcher Typ die angeschlossene Maschine ist (Anspruch 1, Anspruch 30).

Von außen kann dabei in eine jeweilig angeschlossene Maschine "elektrisch hineingesehen" werden, optisch ist ein solcher Einblick in der Regel nur dann möglich, wenn die Maschine auseinandergebaut wird. Der Normalfall des Einblicks endet deshalb meist am Klemmenkasten zum Anschluss der elektrischen Phasen des Umrichters an die elektrischen Phasen der Maschine. Das in einem Testbetrieb vorgenommene elektrische Hineinschauen in die Maschine (Anspruch 1, Merkmale (b) bis (d), Anspruch 27, 28 und 29) erlaubt es, mehrere Winkellagen des Testsignals gegenüber einer Rotorlage zu überprüfen (Anspruch 1, Merkmal (e), Anspruch 27). Dabei kann sowohl der Rotor im wesentlichen un-verdreht verbleiben, wenn sich die verschiedenen Testsignale im Statorsystem umfänglich gegenüber dem Rotor bewegen und eine elektrische Maschine an diskreten Winkellagen, aber im wesentlichen vollumfänglich in der Vergleichsfunktion abbilden, dabei kann aber auch vorgesehen -sein,-dass die Rotorlage verändert wird in einem Drehwinkel und das elektrische Testsignal unverdreht an derselben Winkellage des Stators verbleibt (Anspruch 25). Das Stellsignal bewegt dabei den Rotor in unterschiedliche physische Drehlagen und das elektrische Testsignal als mehrphasiges Testsignal bleibt an derselben Winkellage im Statorsystem stehen.

Werden eine Vielzahl von Rotorlagen angefahren, beispielsweise mehr als 50 Drehlagen, kann man mit guter Gewissheit auf den Typ der angeschlossenen Maschine schließen (Anspruch 26). In gleicher Weise, wie der Rotor verdreht werden kann, kann aber auch das elektrische Testsignal sich umfänglich verlagern, bei im wesentlichen drehlage-gleichem Rotor (Anspruch 24, Anspruch 29). Dass der Rotor sich beeinflusst von elektrischen Testsignalen über die elektrischen Phasen auch geringfügig bewegt, kann nicht ausgeschlossen werden, selbst bei kleinen Signalgrößen und niedrigen Frequenzen. Deshalb ist es günstig, mehrere Richtungswechsel der Wechselsignale vorzunehmen (Anspruch 39), so dass die eine Laufrichtung des ersten Testsignals sich mit der Laufrichtung des beispielsweise zweiten oder eines weiteren Testsignals gegenläufig kompensiert. Eine mehrfache Wechselung ist günstig, um die effektiv erfolgende Drehung des Rotors so gering wie möglich zu gestalten.

In allgemeinen Worten verändert sich die Drehlage der elektrischen Winkel, repräsentiert durch den Flussvektor der Testsignale relativ zu der Drehlage des Rotors, entweder durch Drehung des Rotors oder durch Drehung der elektrischen Winkel des Testsignals (Anspruch 36). Diese relative Lageveränderung macht es möglich, elektrisch in die angeschlossenen Maschinen hineinzuschauen und die Wirkung auf eine zu Vergleichszwecken herangezogene Messgröße bei mehreren verschiedenen. Lagerelationen zu erfassen.

Entsprechend ist auch die Mindestzahl von Messwerten (nach Anspruch 26) zu übertragen auf die Mindestzahl von Winkellagen im Statorsystem bei nacheinander verändertem Testsignal (Anspruch 24). Durch die Winkellagen der Testsignale ist das Abtastraster gegeben, was bevorzugt unter 10° (elektrische Maschine) liegt, bei höheren Auflösungen auch unter 3° liegen kann. Die entsprechende Anzahl der Messwerte ergibt sich bei einem Vergleich mit einem elektrischen Winkel von 360°.

Es versteht sich, dass die diskreten Messwerte zeitlich nacheinander aufgezeichnet werden, also bei mehreren mehrphasigen Testsignalen auch zeitlich beabstandet entstehen (Anspruch 24).

Je kleiner der zeitliche Abstand zwischen dem Anlegen von aufeinander folgenden Testsignalen, desto schneller arbeitet die Erstellung der Vergleichsfunktion, welche der angeschlossenen Maschine zugeordnet ist, bevor der ihren Typ erkennende Vergleich mit der Referenzfunktion vorgenommen wird (Anspruch 1, Merkmal (g)).

Das mehrphasige Testsignal hat seine Bedeutung von den mehreren elektrischen Phasen der angeschlossenen Maschine. Es ist selbst aber auch mehrfach verwendet in dem Sinne, dass mehrere solcher Testsignale nacheinander an die angeschlossene Maschine angelegt werden, wobei diese Vielzahl von Testsignalen, erstes, zweites, drittes usf. Testsignal die Anzahl der diskreten Punkte des zu ermittelnden Verlaufs der Vergleichsfunktion festlegt.

Eine Vielzahl von Testsignalen gibt eine hohe Anzahl von Punkten und damit eine sehr gut nachgebildete Vergleichsfunktion zu der angeschlossenen Maschine. Je gröber die Auflösung, desto ungenauer der Verlauf und desto größer der Einfluss von Ausreißern oder Messwertfehlern, wie das üblicherweise bei Abtastsystemen der Fall ist.

Die Erfindung wird anhand von Ausführungsbeispielen erläutert, vertieft und ergänzt.
- Figur 1: veranschaulicht ein Blockschaltbild mit symbolischen dargestellten Elementen des Regel- und Steuersystems zur Inbetriebnahme einer Mehrphasenmaschine 1 über einen Umrichter 10, der von einem Netz N gespeist wird.
- Figur 2: veranschaulicht eine symbolische Darstellung von identifizierten (gemessenen) Vergleichsfunktionen, aufgetragen über dem Statorwinkel α, für zwei unterschiedliche Maschinentypen, Asynchronmaschine DAM und Synchronmaschine DSM.
- Figur 3: veranschaulicht Referenzfunktionen für mehrere Typen von Mehrphasenmaschine, aufgetragen über dem Statorwinkel α.
- Figur 4: veranschaulicht ein Flussdiagramm (flow-chart) für eine Typerkennung der Mehrphasenmaschine 1 von Figur 1 oder der Figuren 5 während einer Inbetriebnahme (Testbetrieb), also beispielsweise vor einem aktiven Produktivbetrieb eines Motors als Mehrphasenmaschine 1.
- Figur 5a, Figur 5b, Figur 5c: veranschaulichen verschiedene Schnitte, senkrecht zu einer Welle oder Antriebsachse einer Maschine, zur Veranschaulichung von verschiedenen Maschinentypen und der von der Typerkennung verwendeten Winkellagen im Stator, welche mit αᵢ (oder αi) bezeichnet sind.

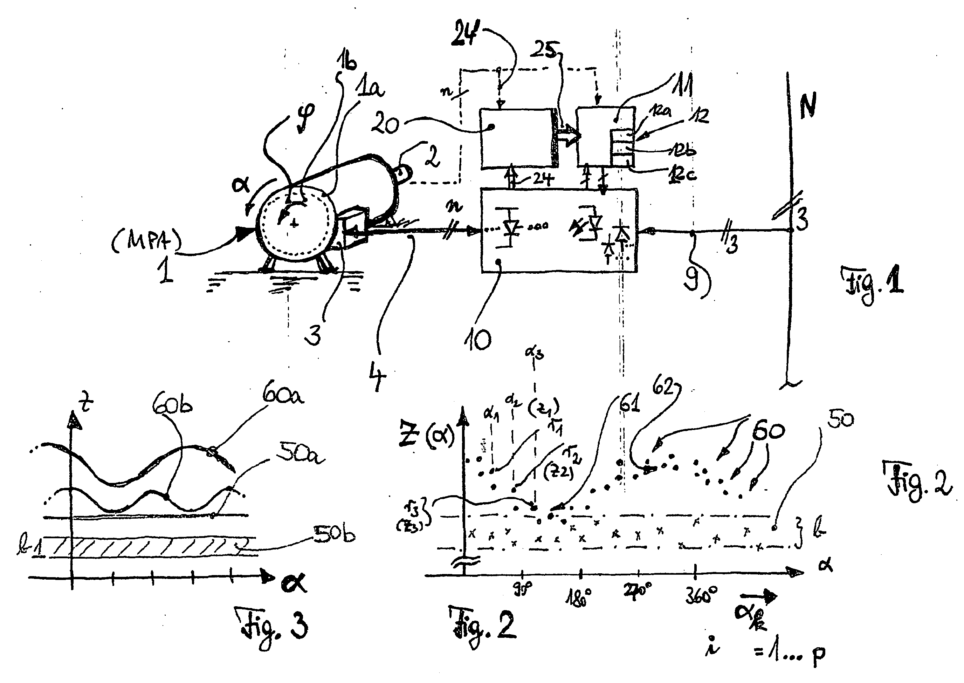

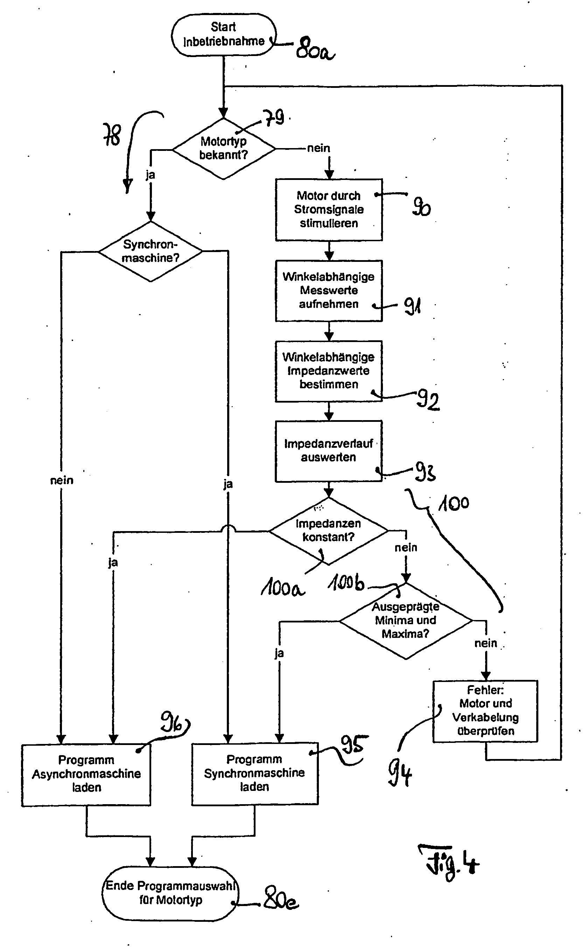

Ein beispielhafter Verfahrensablauf zur Erkennung einer an einen Umrichter 10 angeschlossenen mehrphasigen Maschine ist für einen Motor mit Stator 1 a und Rotor 1b in Figur 4 veranschaulicht. Dieser Ablauf eines Steuerprogramms für eine solche Erkennung ist für das Beispiel in die Inbetriebnahme verlagert. Das Verfahren beginnt mit der Inbetriebnahme 80a und endet mit der von dem Steuerprogramm vorgenommenen Auswahl des zutreffenden Motortyps bei 80e. Dieses Programm ist Teil eines Steuerprogramms 20 nach Figur 1, in welcher das Umfeld gezeigt ist, in welchem die Erkennung im Sinne einer Identifikation vorgenommen wird.

Als Produktivbetrieb wird der normale betriebliche Ablauf der Mehrphasenmaschine 1, auch MPA genannt, angesehen. Vorgelagert sind Inbetriebnahme-Handlungen. Statt einer Inbetriebnahme kann die Ablaufsteuerung nach Figur 4 auch später wiederholt werden, wenn der Motor ausgewechselt wird, ein anderer Motor 1 an seine Stelle kommt oder wenn nach einer Inbetriebnahme in einem ersten Produktivbetrieb keine zuverlässigen Ergebnisse erzielt werden. Der Begriff der Inbetriebnahme soll also allgemein verstanden werden, er umfasst sowohl das erstmalige Inbetriebnehmen, wie auch ein späteres erneutes Inbetriebnehmen, oder ein Verifizieren einer Inbetriebnahme während einer Pause des Produktivbetriebs.

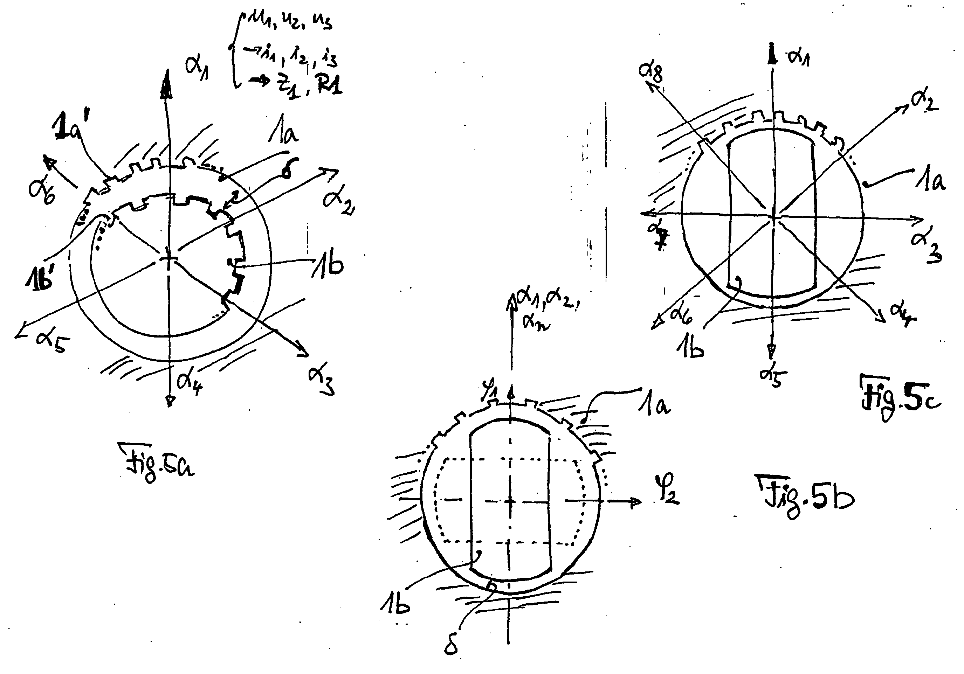

Der hier im Beispiel gezeigte Motor 1 ist eine Möglichkeit einer Mehrphasenmaschine, welche auch Generatoren umfasst. Als mögliche Motoren oder Generatoren kommen Asynchronmaschinen, Synchronmaschinen, spezielle Ausgestaltungen dieser Maschinen, wie Servomotoren, Reluktanzmaschinen und andere Drehfeld-Maschinen, in Frage. Zu erkennen ist ein jeweiliger Typ einer Maschine, wie das im Ablaufdiagramm nach Figur 4 und schematisch in den Figuren 5a, 5b und 5c veranschaulicht wird. Zunächst schließt die Person, welche die Inbetriebnahme vornimmt, den mehrphasigen Motor mit seinen vorhandenen, mehreren elektrischen Phasen (als Wicklungen) an den Umrichter an. Dies geschieht über den Klemmenkasten 3 und eine mehradrige Leitung 4, welche auf der anderen Seite an die Umrichterklemmen angeschlossen wird. Aufgrund der höheren Schaltfrequenz des Umrichters 10 kann diese Leitung abgeschirmt sein. Die gebräuchlichste Anzahl von Phasen ist drei. Es werden im Rahmen der Leitungs-Verbindungen also bevorzugt drei Leitungen (und ein PE Anschluss) verlegt, im Klemmenkasten verschaltet und der Umrichter 10 über eine Steuerung 20 für die Inbetriebnahme in Betrieb genommen.

Der Motor 1 ist mit seiner Abtriebswelle 2 noch nicht an das anzutreibende System mechanisch angekoppelt dargestellt. Dies kann später erfolgen, wenn der Motor erkannt und der Umrichter 10 auf ihn eingestellt worden ist. Der Antrieb kann aber auch bereits an die abtriebsseitige Mechanik angekoppelt sein (über die Welle oder eine anderweitige Kupplung), in welchem Zustand möglichst keine Drehbewegung der Welle (und der Maschine) bei der Erkennung auftreten sollte.

Der Motor nach Figur 1 hat einen symbolisch angedeuteten Stator 1 a und einen symbolisch angedeuteten Rotor 1b. Der Rotor hat einen Rotorwinkel als Drehlage ϕ und einen Statorwinkel α, welcher das Statorsystem symbolisiert.

Am Eingang des Umrichters wird dieser von einem Mehrphasennetz, meist einem Dreiphasennetz N über Zuführleitungen 9 gespeist. Dieses Netz wird symbolisch dargestellt über einen Gleichrichter zu einem Zwischenkreis umgesetzt. Der Zwischenkreis speist eine Leistungs-Endstufe, welche ebenfalls symbolisch mit steuerbaren Leistungshalbleitern dargestellt ist. Diese werden, ebenfalls symbolisch dargestellt, durch LED-Ansteuerungen (bspw. als Optokoppler) von einer Steuerung 11 angesteuert. Diese Steuerung enthält alle für den Umrichter notwendigen Steuerprogramme, Regelprogramme und auch Überwachungsprogramme, welche sich beispielsweise auf Strommessung, Stromüberwachung, Drehzahlüberwachung und andere Mess- und Überwachungsfunktionen beziehen können. Der Steuerteil 11 erhält auch Messwerte aus dem Motor 1, wie Spannungs- und Stromwerte oder ein Lagewert-Verlauf von hier nicht gesondert eingezeichneten - mit der Welle 2 gekoppelten - Gebern.

Zur Steuerung und Inbetriebnahme ist eine gesonderte Steuerschaltung 20 vorgesehen, welche über Steuersignale 25 den Steuerteil 11 des Umrichters 10 beeinflusst, um mittelbar damit auch die Signale an den Ausgangsleitungen 4 sowohl zu beeinflussen, wie auch deren Messsignale zu erhalten und im Rahmen der Figur 4 auswerten zu können.

Die eigentliche Erkennung erfolgt ebenfalls in der Steuerschaltung 20, welche auch als ein Programmsegment oder Steuerprogramm in dem Steuerteil 11 integriert sein kann.

Die vom Umrichter 10 abgegebenen Leistungssignale werden über die Verbindungsleitungen 4 als Stellsignale angesehen. Diese Stellsignale werden, gesteuert und veranlasst von der Steuerschaltung 20, in einem Testbetrieb als Testsignale aufgeschaltet. Diese Testsignale entstehen im Zuge der Steuerung und Regelung im Steuerteil 11 und werden umgesetzt über den Leistungsteil des Umrichters 10, so dass sie dem Motor ebenfalls aufgeprägt oder zugeführt werden, in der einen oder anderen zu beschreibenden Form.

Das Messen von Folgen solcher Testsignale wird durch Signalgeber vorgenommen, wie einer Strommessung, einer Spannungsmessung, einer Drehzahlmessung oder einer Lagemessung, welche nicht gesondert eingezeichnet und im Sektor der Antriebstechnik übliche Messgeber sind. Deren Signale als ursächliche Folgen werden zu der Steuerschaltung 20 zurück übermittelt, was symbolisch über eine mehrere Signale übertragende Verbindung 24 dargestellt ist, oder über Leitungen 24' erfolgen kann.

Ein Stimulieren des Motors 1 mit den genannten mehrphasigen Testsignalen erfordert keine zusätzliche Leitung oder zusätzliche Messgeber, sondern verwendet die natürliche Verbindung zwischen Umrichter und Motor.

Die aus den Testsignalen stammenden Messwerte werden ausgewertet, welche Auswertung weiter unten erläutert wird. Die Auswertung führt zu einer Vergleichsfunktion, welche für zwei unterschiedliche Motortypen, eine Asynchronmaschine und eine Synchronmaschine in Figur 2 mit Punkten (Synchronmaschine) und mit Kreuzen (Asynchronmaschine) dargestellt ist. Die Vergleichsfunktion ist hier ein lmpedanzverlauf Z(α) über dem Statorwinkel α.

Es können mehrere lmpedanzkurven oder Widerstandskurven als Vergleichsfunktionen aufgetragen werden, wobei das Auftragen eine Abspeicherung in einem Speicherbereich ist, nicht zwingend eine optische Präsentation dieses Funktionsverlaufes. Es ist aber zur Darstellung und zur Verdeutlichung der Arbeitsweise der Motorerkennung sinnvoll, diese im Speicherbereich über dem Statorwinkel abgelegten Messwerte graphisch aufzutragen, gegebenenfalls auch für die Person, welche die Inbetriebnahme vornimmt, auf einem Display anzuzeigen. Für die Funktion der Typerkennung ist die sichtbare Darstellung aber nicht erforderlich.

In der Schaltungssteuerung 20 oder in einem Speicherbereich des Steuerteils 11 des Umrichters 10 sind zumindest eine, bevorzugt mehrere Referenzfunktionen gespeichert, von denen einige in Figur 3 veranschaulicht sind. Es sind Referenzfunktionen, von denen jede einem bestimmten Maschinentyp (Motortyp) zugeordnet ist. Jede der Referenzfunktionen repräsentiert einen und nur einen ihr zugeordneten Maschinentyp. Im dargestellten Beispiel sind zwei Referenzfunktionen 50a, 50b vorgesehen, welche Asynchronmaschinen repräsentieren. Die Referenzfunktionen 60a, 60b repräsentieren Synchronmaschinen. Die Referenzkurve 60a repräsentiert eine zweipolige Maschine, während die Referenzfunktion 60b eine vierpolige Maschine darstellt. Aufgetragen ist ebenfalls über dem Winkel α eines angenommenen Motors ein ihn charakterisierender lmpedanzverlauf Z(α) nach Figur 2.

Es ist an Referenzfunktionen nicht unbedingt erforderlich, mehrere Funktionen für denselben Motortyp vorzuhalten, so dass die Speicherung und Vorgabe der Referenzfunktionen 50b und 60a ausreichend wäre, eine Asynchronmaschine und eine Synchronmaschine zu repräsentieren. Bei spezifischen Gestaltungen von Synchronmaschinen oder bestimmten Bauarten von Typen von Motoren, wie Servomotoren, hat es sich aber als vorteilhaft erwiesen, wenn mehrere Referenzfunktionen vorhanden sind, die mit ihrem Verlauf von Widerstands- oder lmpedanzwerten auf bestimmte Motortypen und Bauarten abgestimmt sind, so dass eine zuverlässigere Erkennung des Motors möglich ist.

Ist ein Motortyp erkannt, wird die Steuerumgebung im Steuerteil 11 auf diesen Typ abgestimmt. Das kann dadurch geschehen, dass eines von mehreren Steuerprogrammen 12a, 12b, 12c in einem Programmspeicher 12 ausgewählt oder freigeschaltet wird, während die anderen Steuerprogramme für die anderen Motortypen inaktiv oder stillgelegt bleiben. Das kann aber auch dadurch geschehen, dass aus einem Hauptspeicher das für die Regelung verwendete Steuerprogramm zum erkannten Motortyp in den Arbeitsspeicher geladen wird.

Statt einem Steuerprogramm kann ebenso ein Regelprogramm, wie auch ein Überwachungsprogramm, auf dieselbe Art und Weise vorgegeben werden.

Anschließend ist das Steuerteil 11 auf den Motor abgestimmt und kann den Umrichter 10 entsprechend den Vorgaben der Anwendungs-Umgebung steuern. Der Umrichter ist an die angeschlossene Maschine 1 angepasst.

Ohne die Programmauswahl und ohne den Vergleich ist die Erkennung vorbereitet und es liegt eine Vergleichsfunktion entsprechend der Figur 2 vor, welche zur Bestimmung des Typs des-angeschlossenen Motors verwendet oder eingesetzt werden kann. In schwierig zu erkennenden Fällen, oder wenn die automatische Erkennung unzuverlässige Ergebnisse erbringt, kann eine solche Vergleichsfunktion an einem hier nicht dargestellten, aber zuvor erwähnten Display dem Benutzer angezeigt werden, um es ihm zu ermöglichen, daraus die entsprechenden Schlussfolgerungen zu ziehen. Das Anzeigeergebnis trägt es inhärent in sich, einem bestimmten Motortyp zugeordnet zu sein, der aber möglicherweise nicht zuverlässig genug anhand der im Ablaufprogramm der Steuerschaltung 20 vorhandenen Referenzfunktionen durch automatisierten Vergleich erkannt werden konnte.

Nach Figur 4 beginnt der Start der Inbetriebnahme, nachdem der Motor 1 über die Verbindungsleitungen 4 an den Umrichter 10 angeschlossen worden ist und die Person zur Inbetriebnahme der Steuerschaltung 20 bei 79 mitgeteilt hat, durch Eingabe über ein Bediengerät, dass der Motortyp nicht bekannt ist. Ist der Motortyp bekannt, ist die Erkennung einfach und verläuft entlang des Weges 78. Es werden dann zwei Abfragen nachgeschaltet, ob es eine Synchronmaschine oder Asynchronmaschine ist, gegebenenfalls auch mehrere andere Typen von Generatoren oder Motoren, um das jeweils zugehörige Programm in den Arbeitsspeicher 12 des Steuerteils 11 zu laden.

Bei 96 wird das Programm einer Asynchronmaschine geladen; bei 95 das Programm einer Synchronmaschine. Damit ist der Vorgang der Inbetriebnahme abgeschlossen und der Motortyp durch Vorgabe bzw. Eingabe des Benutzers erkannt. Ist diese Eingabe nicht möglich, verläuft die Motorerkennung an der NO-Abzweigung (Nein) der ersten Abfrage 79.

Der Motor wird in einem ersten Ablaufschritt 90 durch Strom- oder Spannungssignale stimuliert ("bestromt"), welche - wie oben erwähnt- über den Umrichter 10 auf die Ansteuerleitungen 4 aufgeschaltet werden. In einem zweiten Schritt 91 werden winkelabhängige Messwerte aufgenommen. Die Winkelabhängigkeit entspricht dem Statorwinkel a und ist in ihren diskreten Vorgaben mit "i" bezeichnet, so α₁, α₂, α₃, αᵢ, bei i=1 bis p, welche unterschiedliche Statorwinkel und damit unterschiedliche Winkel des Statorfelds 1 darstellen. i ist eine Laufvariable zwischen 1 und p, wobei p bevorzugt zwischen 50 und 360 liegt.

In einem dritten Schritt werden Impedanzen als Beispiele von Auswertungen der -ursächlichen Folgen am Motor-1 bestimmt. Als ursächliche Folgen sind beispielsweise Strom oder Spannung vorgesehen, bei Spannungs- bzw. Stromvorgabe. Das Messen dieser Größen führt zu den Folgen der aufgeschalteten Testsignale. Das Auswerten dieser Folgen kann in dem hier dargestellten Beispiel über die Bestimmung eines Widerstands oder einer Impedanz erfolgen. Diese Impedanz wird für jeden Winkel αᵢ, welcher eingestellt worden ist, in der Auswertung errechnet, als Messwert.

In einem vierten Schritt 93 wird die Vielzahl von ausgewerteten Impedanzen als Impedanzverlauf Z(α) dargestellt und ausgewertet, im Sinne eines Vergleichs dieser Impedanzfunktion mit bevorzugt mehreren vorgegebenen Funktionen, welche in der Figur 3 dargestellt sind. Die Bestimmung des Vergleichs-Impedanzverlaufs entspricht der Figur 2.

Die Zuordnung der bestimmten Impedanzwerte im Schritt 92 kann entweder jeweils nach einer Bestimmung eines Impedanzwertes erfolgen, so dass die Impedanzkurve oder der Impedanzverlauf im Schritt 93 nach und nach entsteht Die Impedanzen können aber auch in der Berechnung zurückgestellt werden, um Messwerte für eine Vielzahl von Drehlagen zunächst zu sammeln, und dann gemeinsam diese Messwerte in Impedanzen umzurechnen und den Impedanzverlauf zu erstellen und abzuspeichern.

Die Auswertung geschieht im Schritt 100. Der Impedanzverlauf wird ausgewertet, ob er konstant oder im Wesentlichen konstant verläuft, was im Schritt 100a erfolgt. Das entspricht einem Impedanzverlauf 50 gemäß Figur 2. Kann diese Abfrage positiv (YES, ja) beantwortet werden, wird die Steuerschaltung 20 das für Asynchronmaschinen einzusetzende Programm 12a bei 96 in den Programmspeicher 12 des Steuerteils 11 laden, veranlassen zu laden oder dieses Programmsegment im Programmspeicher freischalten. Die anderen Programmsegmente 12b, 12c werden dann gesperrt.

Kann die Abfrage 100a nicht positiv beantwortet werden, erfolgt eine weitere Abfrage 100b auf ausgeprägtes Minimum oder Maximum eines lmpedanzverlaufs 60, alternativ auch mehrerer solcher Minima und Maxima für mehrpolige Maschinen. Die Extremwerte werden von den einzelnen berechneten Messwerten r1, r2, ... im Impedanzverlauf Z(α) dargestellt. Kann diese Abfrage 100b positiv beantwortet werden, wird das Programm 12c (oder mehrere Programmteile) für eine Synchronmaschine bei 95 freigeschaltet oder veranlasst zu laden oder geladen, was durch Hereinnehmen oder Einspeichern eines Programmsegments 12c für die Synchronmaschine in den Arbeitsspeicher 12 des Steuerteils 11 erfolgt. Programme 12a, 12b werden gesperrt oder nicht geladen.

Die Abfrage 100 kann auch modifiziert sein und nur aus einer Abfrage 100a bestehen, wenn sichergestellt ist, dass nur zwei Motortypen zur Auswahl stehen und die Verneinung des Vorhandenseins des einen Motortyps automatisch zur Bestimmung führt, dass der andere Motortyp angeschlossen ist.

Diese relativ einfache Abfrage wird in ihrer Zuverlässigkeit aber verbessert, wenn jeder Motortyp, den es zu erkennen gilt, gesondert abgefragt und positiv mit einer entsprechenden Abfrage und einem entsprechenden Vergleich seiner Charakteristika (gemäß einem Vergleich der ihm zugeordneten Vergleichsfunktion mit zumindest einer, bevorzugt aller übrigen anderen Referenzfunktionen) bestätigt wild. Eine Übereinstimmung im Sinne einer größtmöglichen Ähnlichkeit wird so für jeden Motortyp gesondert festgestellt, wenn die Einzelabfragen 100a, 100b vorgesehen sind, um jeden Motortyp gesondert positiv auszuwählen und zu erkennen, nicht über eine Negativauswahl, bei welcher ein Motortyp dadurch festgelegt wird, dass n-1 Motortypen der vorhandenen n-Motortypen nicht zutreffend sein können, so dass es der n-te Motortyp "sein muss".

Kann für einen angeschlossenen Motortyp in dem dargestellten Steuerablauf der Figur 4 bei zwei angenommenen Motortypen keine der Abfragen 100a, 100b positiv beantwortet werden, liegt angenommener-maßen ein Fehler in der Verschaltung oder des Systems vor. Es müssen Motor und Verkabelung überprüft werden, was durch den Schritt 94 vorgegeben wird. Danach beginnt das Erkennungsverfahren erneut, entweder durch Abfrage 79 des Motortyps - wie dargestellt - oder gleich durch Abfrage einer Freigabe, welche vom Benutzer erteilt wird, und die Stimulierung des Motors an unterschiedlichen Winkelpositionen gemäß Schritt 90.

Die in Figur'4 vereinfacht dargestellte Abfrage 100a, 100b im Sinne einer Erkennung 100 kann auch mehrere Staffeln und mehrere Abfragen umfassen, wie eingangs anhand der mehreren Referenzfunktionen der Figur 3 erläutert war.

Die symbolisch und vereinfacht dargestellten "Abfragen" können auch Berechnungen umfassen, welche die ermittelte Referenzfunktion 50 oder 60 mit zumindest einer, bevorzugt allen in der Steuerschaltung 20 vorhandenen Referenzfunktionen 60a, 60b, 50a, 50b umfasst. Der Vergleich kann durch bekannte Berechnungsweisen, insbesondere solche der Statistik vorgenommen werden. Ein Beispiel für eine Möglichkeit, zwei Funktionen auf Ähnlichkeit zu überprüfen ist die Korrelation. Sie tritt dann an die Stelle der Abfragen 100 des Ablaufdiagramms von Figur 4.

Die Testsignale, welche eingesetzt werden können, sind vielfältig. Es können statistische Signale aufgeprägt werden, es können Wechselsignale aufgeprägt werden, es kann mit Impulssignalen gearbeitet werden, und es kann ein kurzes Wechselsignal vorgegeben sein, welches nur für die Dauer des Beibehaftens eines Messwinkels αᵢ über die Verbindungsleitungen 4 dem Motor zugespeist wird. Alle Testsignale sind mehrphasig, in den meisten Fällen wird es sich um dreiphasige Testsignale handeln, die gemeinsam auf den Motor einwirken, über seine Anschlussleitungen 4.

Verschiedene Arten der Testsignalgewinnung sind einmal eine Modulation auf der d-q-Seite einer Feldorientierung. Es kann aber auch an anderen Stellen des Signalschaltplans eine entsprechende Stimulierung des Motors 1 erfolgen, wobei die mehreren, insbesondere drei Spannungswerte, welche den drei Phasen aufgeprägt werden, die Winkelstellung oder Lage α festlegen, zu der eine zugehörige Testantwort gehört (als ursächliche Folge).

Es muss kein langsam umlaufendes Statorfeld sein, welches als Vektor einer Feldorientierung den Motor 1 am Umfang abtastet. Es können auch einzelne Abtastpunkte sein, die nicht unmittelbar aufeinander folgen müssen. Sie sind nur dann bei der Bestimmung des Verlaufs, bspw. der Impedanz, wieder richtig zuzuordnen.

Signalpulse sind auf der Ausgangsseite des Umrichters 10 als Spannungspulse ebenso möglich, wie ein auf drei Phasen moduliertes Spannungssystem, das selbst mit dem Vektor einer Feldorientierung langsam umläuft.

Das Flussschaltbild mit d/q Orientierung ist ein Beispiel für eine Berechnung, bei dem Impedanzwerte Z(α) als Funktion von α (Statorwinkel) eingesetzt werden. Ebenso können Stromwerte eingesetzt werden, wenn sie eine (ursächliche) Folge des Eingangssignals sind, das als Testsignal (Stimulierungssignal) verwendet wird.

Der in den Figuren 2 und 3 erläuterte Vergleich, welcher im Ablaufdiagramm in dem Bereich 100 erfolgt, soll näher erläutert werden.

Die im Beispiel verwendete Rechengröße "Impedanz" wird für eine Vielzahl von Lagen bestimmt, welche als diskrete Größen α₁, α₂, α₃, ... αᵢ, lauten, und zwar durch Auswerten von Messwerten im Sinne einer Berechnung eines Impedanzwertes, gestützt auf Strommessung und Spannungsmessung.

Auch andere Rechengrößen können Anwendung finden. Es kann statt einer Berechnung auch unmittelbar ein Stromsignal zur Aufzeichnung und zur Zuordnung zur Vergleichsfunktion verwendet werden.

Was verglichen wird, muss aber vergleichbar sein, so dass die Abszisse, hier der Statorwinkel, vergleichbar sein muss mit den Referenzufunktionen nach Figur 3, und die Ordinate, hier der Impedanzwert, ebenfalls vergleichbar sein muss. Werden Stromwerte, Spannungswerte oder Lagewerte oder Drehzahlwerte aufgetragen, um Vergleiche durchzuführen, haben die Referenzfunktionen nach Figur 3 die entsprechende Gestalt bzw. Funktionen.

Die mehrphasige Stimulierung über die Steuerleitungen 4 durch ein hier nicht gesondert dargestelltes, aber oben erläutertes Testsignal wird diskret an mehreren α-Werten, also mehreren Statorwinkeln des Motors 1 vorgenommen.

Es kann auch eine langsame Veränderung des Winkels in einem Bereich von 1Hz an Drehzahl erfolgen, so dass zum jeweiligen Zeitpunkt kurzzeitige Testsignale aufgeschaltet werden, die dann einer festen diskreten Winkellage zugeordnet werden. Die Testsignale haben dabei eine deutlich höhere Frequenz, als die Drehlfeldfrequenz ω_{d}, welche den Rotor der noch nicht erkannten Mehrphasenmaschine bewegt.

Für eine solche Bewegung und eine solche Ansteuerung im Sinne einer bloßen Steuerung und einer Vorgabe eines Signals ist die Regelung noch nicht auf den Motortyp abzustimmen, sie kann vielmehr auch unabhängig davon erfolgen, ob der Motortyp bereits bekannt ist.

Das auf die Steuersignale aufgeprägte oder nur an der festliegenden Winkellage vorgegebene kurzzeitige Frequenzsignal als Beispiel eines Testsignals hat bevorzugt eine Frequenz von mehreren 10Hz, um die Mehrphasenmaschine 1 an ihrer für die Messung vorgegebenen Drehlage nicht zu verändern. Das Wechselsignal als Testsignal kann auch höher in der Frequenz gewählt sein, oberhalb von 100Hz. Sofern es statistische oder Impulssignale sind, liegen die verwendeten Frequenzen ohnehin weit über der genannten niedrigsten Frequenz von 10Hz.

Als Ergebnis sind Messwerte aufzuzeichnen, welche als "ursächliche Folge" des Testsignals angesehen werden (Testantwort). Aus diesen Messsignalen werden entweder Messwerte bestimmt, wie beispielsweise die Impedanz Z, oder andere Rechengrößen, welche zum Vergleich anhand einer Referenzfunktion und einer Vergleichsfunktion anstehen.

Die Anzahl der so aufgenommenen und ausgewerteten sowie einer Vergleichsfunktion zugewiesenen Messwerte r1, r2, ... sollte nicht zu gering gewählt werden. Versuche haben gezeigt, dass 50 Messwerte entlang eines Verlaufs eines elektrischen Drehwinkels schon zuverlässige Ergebnisse bringen. Höhere Genauigkeit wird erzielt, wenn mehr Testwerte erfasst werden, so bis zu 360 Werten, bei einem Winkelinkrement von 1°. Gegebenenfalls reichen schon Winkeldifferenzen (Inkremente) von 10° bis unter 3° (120 Messwerte).

Es ergibt sich naturgemäß eine nicht stetig verlaufende Funktion als Graph der Vergleichsfunktion 50, welcher eine gewisse Bandbreite der Messwerte um eine ideale, stetige Funktion herum aufweist. In Figur 2 ist dieses für eine Synchronmaschine mit den Messwerten bzw. Rechenwerten im Verlauf 60 veranschaulicht, wie es für eine Asynchronmaschine in einem Bandbreiten-Bereich b beim Verlauf 50 gezeigt wird.

Es kann nie vermieden werden, dass Ausreißer aus einem angenäherten Verlauf auch vorhanden sind, welche in einer Vorfilterung oder Plauiibilftäts-Kontrolle vorab als zu stark von einem Mittelwert abweichend ausgesondert werden können, um das reale Messergebnis nicht zu verfälschen. Es verbleiben dann in einer Bandbreite liegende Mess- oder Rechenwerte für eine physikalische Größe, hier der Impedanz Z, die einen Vergleich mit Referenzfunktionen nach Figur 2 erlaubt. Die Funktion 60 für eine DSM (Synchronmaschine) hat ein ausgeprägtes Minimum 61 und ein ausgeprägtes Maximum 62, hingegen besitzt die Funktion 50 als eine andere ermittelte Vergleichsfunktion einer angeschlossenen Asynchronmaschine kein solches ausgeprägtes Maximum oder Minimum. Es finden sich alle Mess- oder Rechenwerte im Rahmen eines Toleranzbandes, das im Bereich von ±20% oder unter ±10% oder darunter gewählt werden kann. Die Bezugsgröße ist der Mittelwert aus allen Messungen (aller Testsignale).

Dieses Toleranzband kann entweder bei der Erkennung der Funktion der Figur 2 verwendet werden, oder es kann bei der Referenzgröße gemäß Funktion 50b mit einem Toleranzband b1 dem Vergleich zugrunde gelegt werden, ohne die einzelnen Rechen- oder Messwerte des Funktionsverlaufs 50 in der Figur 2 schon auszuwerten oder zu analysieren. Liegen eine Vielzahl der gefundenen Rechen- oder Messwerte innerhalb des Vergleichsbandes b1, kann auf eine Asynchronmaschine im Rahmen der Entscheidungsfindung 100 nach Figur 4 geschlossen werden.

Zur Festlegung des Toleranzbandes bietet sich die Mittelwertbildung an. Eine Mittelwertbildung aller gemessenen Größen ist Vorgabe für die Prozentangabe des zu erlaubenden Toleranzbandes, wenn daraufhin analysiert werden soll, ob alle gemessenen Werte "im Wesentlichen konstant" verlaufen, also innerhalb eines gegebenen Toleranzbandes liegen, oder kein ausgeprägtes Maximum oder Minimum besitzen.

Mehrere Referenzfunktionen, beispielsweise 50a, 50b können auf denselben Typ schließen lassen, einmal für eine genauere Erkennung einer Konstanz der Messwerte bei 50a und einmal für eine größere Toleranzbreite b1 bei Referenzfunktion 50b.

Referenzfunktionen für Synchronmaschinen können abhängig von der Polzahl unterschiedliche Anzahlen von Minima und Maxima aufweisen. Hier kann man auch eine Normierung vornehmen, die dafür sorgt, dass regelmäßig nur ein Minimum und ein Maximum verglichen wird, entsprechend der Referenzfunktion 60a.

Ergibt die Identifikation nach Figur 2 mehrere Minima und Maxima, wird die Funktion 60a entsprechend gestaucht, um als Vergleichsmaßstab dienen zu können.

Die einzelnen, diskreten Messwerte bei α1,α2,α3, wobei der Index i von 1 bis p läuft, bilden die Vergleichsfunktion nach Figur 2. Statt Impedanzwerten zᵢ können auch Widerstandswerte rᵢ angenommen werden.

Aufgetragen werden für das Beispiel, bei dem der Rotorwinkel ϕ praktisch unverändert bleibt, die Messwerte im Statorsystem α. Wenn die einzelnen Testsignale zeitlich beabstandet so aufgeschaltet werden, dass sie unterschiedliche Laufrichtungen haben und dabei als Wechselsignale auch klein in der Amplitude ausgebildet sind, ergibt sich kaum eine Bewegung des Rotors 1b. Begünstigend wirkt hier, wenn die Wechselsignale nacheinander unterschiedliche Laufrichtung annehmen, was durch Umpolen der Phasen im Steuersystem vorgenommen wird. Ein häufiges Wechseln sorgt dafür, dass die Bewegungen des Rotors sich effektiv (über die Testdauer) zu praktisch Null akkumulieren.

Wird in einem alternativen Fall der Rotor über seinem Rotor-Lagewinkel ϕ verändert, bleibt der Winkel α des Testsignals im wesentlichen gleich. Beide Möglichkeiten erlauben eine relative Verdrehung von Rotorlage und Winkellage des Testsignals.

Die Figuren 5a bis 5c zeigen Schnitte von verschiedenen Motoren mit Rotor 1 b und Stator 1a.

Symbolisch ist in Figur 5a eine Nutung 1a' des Stators und eine Nutung 1b' des Rotors vorgesehen, in welche die Wicklungen von Stator bzw. Rotor eingelegt sind. Der Luftspalt δ (delta) ist in den Schnitten ersichtlich. Durch die jeweilige Wicklung wird bei einem "Bestromen" von Stator und/oder Rotorwicklung ein jeweiliger Strombelag mit der Folge eines Magnetfeldes im Luftspalt erzeugt, der durch das mehrphasige Testsignal positioniert wird und damit wird auch eine Winkellage des Flussvektors des Testsignals vorgegeben, welche bei der asynchronen Maschine nach Figur 5a mit sechs diskreten Winkellagen α1 bis α6 vorgegeben wird.

Wird bei der Maschine nach Figur 5a in der Folge α1, dann α2,α6, dann α3,α5, schließlich α4 gemessen, ergibt sich über Alles kaum eine effektive Drehung des Rotors 1 b gegenüber dem Stator 1 a. Eine so mit sechs Testsignalen bei Statorlagen α1 bis α6 ermittelte Vergleichsfunktion für die Maschine der Figur 5a würde der Funktion 50 von Figur 2 als Asynchronmaschine entsprechen. Der Rotor weist an seinem Umfang keine wesentlichen Schwankungen des Luftspalts auf.

In Figur 5b ist eine Synchronmaschine dargestellt die durch Steuersignale mit ihrem Rotorwinkel ϕ des Rotors 1 b verändert wird und bei der der Statorwinkel α1,α2 ... αn immer an der selben Winkellage des Stators verbleibt.

Der Nullwinkel ϕ1 des Rotors und Stators wird-während der Messung verlassen, aber die relative Lage zwischen Rotor und Stator erlaubt es, eine Funktion 60 als Vergleichsfunktion nach Figur 2 zu messen und im Speicher des Steuerteils 11 abzuspeichern. Symbolisch ist die Drehlage ϕ2 der Rotors strichliniert eingezeichnet, die einer Winkellage α im Stator von α=-90° entspricht, wenn der Rotor bei ϕ1 verblieben wäre.

Figur 5c veranschaulicht schließlich eine Messung einer Synchronmaschine, entsprechend der Vorgabe einer praktisch unveränderlichen mechanischen Drehlage ϕ des Rotors 1b, und eines diskret sich verändernde Statorwinkels αi für die mehreren Testsignale, von denen im dargestellten Beispiel acht eingesetzt werden, von i=1 bis i=8. Daraus ergibt sich eine Vergleichsfunktion 60 nach Figur 2 mit acht diskreten Punkten (Messwerten), die in ihrem Verlauf ein ausgeprägtes Minimum und ein ausgeprägtes Maximum aufweisen.

## Patentansprüche

1. Verfahren zur Erkennung eines Maschinentyps einer an einem mehrphasigen Umrichter (10) angeschlossenen Mehrphasenmaschine (1), deren Maschinentyp bei Beginn des Erkennungsverfahrens nicht bekannt ist oder ungewiss ist, mit folgenden Schritten des Maschinentyp-Erkennungsverfahrens
(a) Anschließen der mehrphasigen Maschine mit ihren mehreren elektrischen Phasen an den mehrphasigen Umrichter (10);
(b) Aufschalten eines ersten Testsignals von dem Umrichter (10) auf zumindest eine, bevorzugt einige der mehreren elektrischen Phasen der angeschlossenen Mehrphasenmaschine (1);
(c) Messen von zumindest einer ursächlichen Folge des ersten Testsignals;
(d) Auswerten des Messergebnisses als ursächliche Folge zum Erhalt eines ersten Messwertes (r1);
(e) zumindest einmaliges Wiederholen der Schritte (b) bis (d) für zumindest ein weiteres Testsignal, zum Erhalt zumindest einer weiteren ursächlichen Folge und zumindest eines weiteren Messwerts (r2);
(f) Zuordnen des ersten und zweiten Messwertes zu einer Vergleichsfunktion (60,50);
(g1) Vergleichen der Vergleichsfunktion mit zumindest einer von mehreren Referenzfunktionen (60a,60b,50a,50b), welche jede einen Typ einer Mehrphasenmaschine repräsentiert,
(g2) wobei zwei der Referenzfunktionen nicht denselben Typ von Maschine repräsentieren, und die zwei Referenzfunktionen zu zwei nicht gleichen, mehrphasigen Maschinentypen gehören, ausgewählt aus der Gruppe: Asynchronmaschine, Synchronmaschine, Reluktanzmaschine, synchronähnliche Maschine und Servoantrieb;
(g3) um die Referenzfunktion auszuwählen, welche der Vergleichsfunktion (50,60) am ähnlichsten ist;
(h) Vorgabe (25) eines von mehreren im Umrichter (10) verfügbaren Systemprogrammen (12a,12b,12c) anhand der ausgewählten Referenzfunktion;
zur Anpassung des Umrichters (10) an den Typ der von ihm anzusteuernden Mehrphasenmaschine.

2. Verfahren nach Anspruch 1, wobei die Vergleichsfunktion für zumindest eine, bevorzugt alle Wicklungen, d.h. elektrische Phasen, des Mehrphasenmaschine erstellt wird, mit mehreren Messergebnissen von mehreren Testsignalen, welche mehreren Messergebnisse die Vergleichsfunktion nach und nach bilden durch ein erweitern bzw. ergänzen.

3. Verfahren nach Anspruch 2, wobei die Vergleichsfunktion mit mehreren Referenzfunktionen verglichen wird, um die ähnlichste davon zu bestimmen und mit ihr den zugehörigen Maschinentyp.

4. Verfahren nach Anspruch 3, wobei zumindest zwei Referenzfunktionen nicht denselben Typ von Mehrphasenmaschine repräsentieren.

5. Verfahren nach Anspruch 1 oder 3, wobei eine der Referenzfunktionen (50a) eine Asynchronmaschine als Mehrphasenmaschine repräsentiert.

6. Verfahren nach Anspruch 5, 3 oder 1, wobei eine der Referenzfunktionen (60a) eine Synchronmaschine als Mehrphasenmaschine repräsentiert.

7. Verfahren nach Anspruch 1, wobei die Wiederholung nach Merkmal (e) an zumindest einer anderen elektrischen Phase (Wicklung) der Maschine (1) vorgenommen wird, als die Schritte (b) bis (d) zum Erhalt des ersten Messwerts (r1).

8. Verfahren nach Anspruch 1, wobei der Umrichter einen Steuerteil (11) und einen Leistungsteil (10) aufweist.

9. Verfahren nach Anspruch 1, wobei der Umrichter eine Leistungseinrichtung ist, welche Leistungs-Stellsignale über mehrere elektrische Ausgangsphasen abgibt (n,4) und die Stellsignale aus einem Zwischenkreis gewinnt, welcher von einem Gleichrichter aus einem Netz gespeist wird (9,N).

10. Verfahren nach Anspruch 1, wobei die Vergleichsfunktion (60, 50) und die zumindest eine Referenzfunktionen (50a,60a) die gleiche physikalische Größe als Abfolge von Messwerten (r1, r2) über derselben Systemgröße (α) abbilden.

11. Verfahren nach Anspruch 10, wobei die physikalische Größe ein Widerstand oder eine Impedanz (Z) über einem Stator winkel bzw. Statorfeldwinkel (α) der angeschlossenen Mehrphasenmaschine ist.

12. Verfahren nach Anspruch 10, wobei ein Verlauf der physikalischen Größe als Messwertabfolge in der Referenzfunktion (50a,50b) im Wesentlichen konstant über einem Statorwinkel (α) verläuft.

13. Verfahren nach Anspruch 10 oder 12, wobei zumindest eine Referenzfunktion (50a,50b) kein ausgeprägtes Maximum und kein ausgeprägtes Minimum aufweist.

14. Verfahren nach Anspruch 10, wobei ein Verlauf der physikalischen Größe zumindest einer Referenzfunktion zumindest ein ausgeprägtes Minimum und zumindest ein ausgeprägtes Maximum aufweist (60a,60b).

15. Verfahren nach Anspruch 11, wobei zumindest die überwiegende Anzahl der gemessenen und als Messwerte ermittelten Widerstands- oder Impedanzwerte (r1,r2,...) über dem Statorwinkel (α) aufgetragen, innerhalb eines Bandes (b) liegen, welches von nicht mehr als im Wesentlichen ±20% eines Mittelwerts gebildet wird, der sich aus den Messwerten ergibt, insbesondere innerhalb eines Bandes von unter ±10% des Mittelwerts.

16. Verfahren nach einem der vorigen Ansprüche 11 bis 15, wobei die Messgröße aus der gemessenen ursächlichen Folge des ersten Testsignals eine andere physikalische Größe ist, als Impedanz oder Widerstand.

17. Verfahren nach Anspruch 1 oder 10, wobei mehrere Messergebnisse ausgewertet werden und der Vergleichsfunktion als mehrere Messwerte zugeordnet werden (50,60), wobei die Auswertung eine Umrechnung beinhaltet, zur Bestimmung eines Messwerts aus dem Messergebnis, beispielsweise eine Widerstands- oder lmpedanzberechnung aus einer Strommessung.

18. Verfahren nach Anspruch 1, wobei die mehreren Systemprogramme (12a,12b,12c) für mehrere Typen von Mehrphasenmaschinen (1) stehen, insbesondere als Regelprogrammteil, Steuerprogrammteil oder Überwachungs-Programmteil.

19. Verfahren nach Anspruch 1, wobei die zumindest eine ursächliche Folge eine oder mehrere von Strom, Spannung, Drehzahl oder Lageänderung sind.

20. Verfahren nach Anspruch 1, wobei das zumindest erste Testsignal ein stationäres Wechselsignal, ein Impulssignal oder ein kurzzeitiges Frequenz-Wechselsignal ist.

21. Verfahren nach Anspruch 20, wobei das Wechselsignal eine Frequenz von zumindest 10Hz, insbesondere ein Mehrfaches davon besitzt, um einen Rotor der Mehrphasenmaschine nicht wesentlich in seiner Drehlage (ϕ) zu verändern. während das Wechselsignal an den elektrischen Phasen oder Wicklungen der Mehrphasenmaschine (1) anliegt.

22. Verfahren nach Anspruch 1, 2 oder 20, wobei ein jeweiliges Testsignal auf die mehreren Phasen zugleich aufgeprägt wird und ein jeweiliges mehrphasiges Testsignal ist.

23. Verfahren nach Anspruch 20 oder 21, wobei das erste Testsignal eine Frequenz oberhalb von im Wesentlichen 100Hz besitzt.

24. Verfahren nach Anspruch 1, 20 oder 23, wobei ein Wechsel-Grundsignal unter im Wesentlichen 10Hz als Mehrphasen-Stellgröße den Rotor (1b) der Mehrphasenmaschine (1) langsam in seiner Drehlage (ϕ) umlaufen lässt, und mehrere Testsignale auf die Mehrphasen-Stellgröße in einem zeitlichen Abstand aufmoduliert werden.

25. Verfahren nach Anspruch 1 oder 20, wobei der Rotor (1 b) der Mehrphasenmaschine mit einem Stellsignal an mehrere nicht gleiche, d.h. unterschiedliche, Rotorlagen (ϕ1,ϕ2) bewegt wird, um an einer jeweiligen Drehlage verbleibend ein jeweiliges Testsignal auf die elektrischen Phasen aufzuschalten und die jeweilige ursächliche Folge zu messen, für die Auswertung zu mehreren Messwerten für die Vergleichsfunktion (50,60).

26. Verfahren nach Anspruch 25, wobei eine Vielzahl von Rotorlagen (ϕ), insbesondere mehr als 50 Drehlagen der Mehrphasenmaschine angefahren und hinsichtlich der jeweils ursächlichen Folge bei einem jeweiligen Testsignal gemessen werden.

27. Verfahren nach Anspruch 1, wobei die Schritte (b) bis (d) für ein weiteres Testsignal, zum Erhalt eines weiteren Messwerts (r2) wiederholt werden.

28. Verfahren nach Anspruch 27, wobei die Wiederholung mehrfach erfolgt, bis eine mit mehreren Messwerten versehene Vergleichsfunktion (50,60) gebildet ist, welche mit der zumindest einen Referenzfunktion (60a,60b,50a,50b) verglichen wird, nach Merkmal (e) des Anspruchs 1.

29. Verfahren nach Anspruch 27 oder 28, wobei jedes weitere mehrphasige Testsignal als zweites, drittes usf. Testsignal ein Mehrphasensignal ist, zur Bildung mehrerer Flusslagevektoren im Statorsystem (α) der Maschine (1), welche Vektoren an unterschiedlichen Winkellagen (α1,α2,α3) des Stators gelegen sind, bei praktisch nicht bewegtem Rotor (1b).

## Claims

1. Process for the detection of a machine type of a polyphase machine (1) connected to a polyphase converter (10), the machine type of which is not known or is uncertain at the start of the detection process, having the following steps of the machine type detection process
(a) connecting the polyphase machine with its several electrical phases to the polyphase converter (10);
(b) adding-on a first test signal from the converter (10) to at least one, preferably a few, of the several electrical phases of the connected polyphase machine (1);
(c) measuring at least one causal sequence of the first test signal;
(d) evaluating the measured result as the causal sequence to obtain a first measured value (r1);
(e) at least single repetition of steps (b) to (d) for at least one further test signal to obtain at least one further causal sequence and at least one further measured value (r2);
(f) assignment of the first and second measured value to a comparison function (60, 50);
(g1) comparison of the comparison function with at least one of several reference functions (60a, 60b, 50a, 50b), each of which represents a type of polyphase machine,
(g2) wherein two of the reference functions do not represent the same type of machine, and the two reference functions belong to two non-similar, polyphase machine types, selected from the group: asynchronous machine, synchronous machine, reluctance machine, machine similar to synchronous and servo-drive;
(g3) in order to select the reference function which is the most similar to the comparison function (50, 60);
(h) default (25) of one of several system programs (12a, 12b, 12c) available in the converter (10) using the selected reference function;
for adaptation of the converter (10) to the type of polyphase machine to be controlled by it.

2. Process according to claim 1, wherein the comparison function is generated for at least one, preferably all windings, that is electrical phases, of the polyphase machine, using several measured results from several test signals, which several measured results gradually form the comparison function by expansion or supplement.

3. Process according to claim 2, wherein the comparison function is compared with several reference functions in order to determine the most similar thereof and with it the associated machine type.

4. Process according to claim 3, wherein at least two reference functions do not represent the same type of polyphase machine.

5. Process according to claim 1 or 3, wherein one of the reference functions (50a) represents an asynchronous machine as the polyphase machine.

6. Process according to claim 5, 3 or 1, wherein one of the reference functions (60a) represents a synchronous machine as the polyphase machine.

7. Process according to claim 1, wherein repetition according to feature (e) is carried out on at least one further electrical phase (winding) of the machine (1) as steps (b) to (d) to obtain the first measured signal (r1).

8. Process according to claim 1, wherein the converter has a control part (11) and a power part (10).

9. Process according to claim 1, wherein the converter is a power device which emits (n, 4) power adjusting signals over several electrical output phases and recovers the adjusting signals from an intermediate circuit which is supplied (9, N) by a rectifier from a power supply.

10. Process according to claim 1, wherein the comparison function (60, 50) and the at least one reference functions (50a, 60a) reproduce the same physical dimension as a sequence of measured values (r1, r2) over the same system dimension (α).

11. Process according to claim 10, wherein the physical dimension is a resistance or an impedance (Z) over a stator angle or stator field angle (α) of the connected polyphase machine.

12. Process according to claim 10, wherein a path of the physical dimension as a measured value sequence in the reference function (50a, 50b) runs essentially constantly over a stator angle (α).

13. Process according to claim 10 or 12, wherein at least one reference function (50a, 50b) has no distinct maximum and no distinct minimum.

14. Process according to claim 10, wherein a path of the physical dimension has (60a, 60b) at least one reference function, at least one distinct minimum and at least one distinct maximum.

15. Process according to claim 11, wherein at least the predominant number of measured resistance or impedance values and those determined as measured values (r1, r2, ...) plotted over the stator angle (α), lie within a band (b) which is formed by not more than essentially ± 20% of an average value which is produced from the measured values, in particular within a band of below ± 10% of the average value.

16. Process according to one of the previous claims 11 to 15, wherein the measured dimension from the measured causal sequence of the first test signal is a different physical dimension than impedance or resistance.

17. Process according to claim 1 or 10, wherein several measured results are evaluated and are assigned (50, 60) to the comparison function as several measured values, wherein the evaluation contains a conversion to determine a measured value from the measured result, for example a resistance or impedance calculation from a current measurement.

18. Process according to claim 1, wherein the several system programs (12a, 12b, 12c) represent several types of polyphase machines (1), in particular as regulating program part, control program part or monitoring program part.

19. Process according to claim 1, wherein the at least one causal sequence is one or more of current, voltage, speed or positional change.

20. Process according to claim 1, wherein the at least first test signal is a stationary alternating signal, a pulse signal or a short-term frequency alternating signal.

21. Process according to claim 20, wherein the alternating signal has a frequency of at least 10 Hz, in particular a multiple thereof, in order not to change a rotor of the polyphase machine substantially in its rotational position (ϕ), whereas the alternating signal exists at the electrical phases or windings of the polyphase machine (1).

22. Process according to claim 1, 2 or 20, wherein a particular test signal is imposed on the several phases at the same time and is a particular polyphase test signal.

23. Process according to claim 20 or 21, wherein the first test signal has a frequency above essentially 100 Hz.

24. Process according to claim 1, 20 or 23, wherein an alternating base signal below essentially 10 Hz as polyphase adjusting dimension lets the rotor (1b) of the polyphase machine (1) rotate slowly in its rotational position (ϕ), and several test signals are modulated onto the polyphase adjusting dimension at a time interval.

25. Process according to claim 1 or 20, wherein the rotor (1b) of the polyphase machine is moved by an adjusting signal at several non-similar, that is different, rotor positions (ϕ1, ϕ2) in order to add-on a particular test signal to the electrical phases in persistent manner at a particular rotational position and to measure the particular causal sequence for evaluation at several measured values for the comparison function (50, 60).

26. Process according to claim 25, wherein a plurality of rotor positions (ϕ), in particular more than 50 rotational positions of the polyphase machine, are started and measured with respect to the particular causal sequence for a particular test signal.

27. Process according to claim 1, wherein the steps (b) to (d) are repeated for a further test signal to obtain a further measured value (r2).

28. Process according to claim 27, wherein the repetition is effected several times until a comparison function (50, 60) provided with several measured values is formed, and which is compared with the at least one reference function (60a, 60b, 50a, 50b), according to feature (e) of claim 1.

29. Process according to claim 27 or 28, wherein each further polyphase test signal as second, third etc. test signal is a polyphase signal to form several flow position vectors in the stator system (α) of machine (1), which vectors are placed at different angular positions (α1, α2, α3) of the stator for a virtually non-moved rotor (1b).

## Revendications

1. Procédé de reconnaissance d'un type de machine polyphasée (1) connectée à un convertisseur polyphasé (10) et dont le type de machine n'est pas connu ou est incertain au début du procédé de reconnaissance, procédé de reconnaissance du type de machine qui comprend les étapes suivantes :
(a) on connecte la machine polyphasée avec ses multiples phases électriques au convertisseur polyphasé (10) ;
(b) on émet un premier signal d'essai au moyen du convertisseur (10) sur au moins une, de préférence quelques-unes des multiples phases électriques de la machine polyphasée connectée (1) ;
(c) on mesure au moins une conséquence causale du premier signal d'essai ;
(d) on exploite le résultat de mesure comme conséquence causale pour obtenir une première valeur de mesure (r1) ;
(e) on répète au moins une fois les étapes (b) à (d) pour au moins un autre signal d'essai, afin d'obtenir au moins une autre conséquence causale et au moins une autre valeur de mesure (r2) ;
(f) on affecte les première et seconde valeurs de mesure à une fonction de comparaison (60, 50) ;
(g1) on compare la fonction de comparaison à au moins une parmi de multiples fonctions de référence (60a, 60b, 50a, 50b), qui représentent chacune un type de machine polyphasée,
(g2) deux des fonctions de référence ne représentant pas le même type de machine et les deux fonctions de référence appartenant à deux types de machines polyphasées non identiques choisies dans le groupe suivant : machine asynchrone, machine synchrone, machine à reluctance, machine similaire à la machine synchrone et servocommande ;
(g3) pour choisir la fonction de référence, qui est la plus semblable à la fonction de comparaison (50, 60) ;
(h) on détermine (25) un programme parmi de multiples programmes du système (12a, 12b, 12c) disponibles dans le convertisseur (10) à l'aide de la fonction de référence choisie ;
pour adapter le convertisseur (10) au type de la machine polyphasée qu'il doit commander.

2. Procédé selon la revendication 1, dans lequel la fonction de comparaison est établie pour au moins un enroulement, de préférence pour tous les enroulements, c'est-à-dire les phases électriques, de la machine polyphasée, avec de multiples résultats de mesure de multiples signaux d'essai, lesquels multiples résultats de mesure forment progressivement la fonction de comparaison par extension ou parachèvement.

3. Procédé selon la revendication 2, dans lequel la fonction de comparaison est comparée à de multiples fonctions de référence pour déterminer celle qui en est la plus semblable et, avec celle-ci, le type de machine correspondant.

4. Procédé selon la revendication 3, dans lequel au moins deux fonctions de référence ne représentent pas le même type de machine polyphasée.

5. Procédé selon la revendication 1 ou 3, dans lequel une des fonctions de référence (50a) représente une machine asynchrone comme machine polyphasée.

6. Procédé selon la revendication 5, 3 ou 1, dans lequel une des fonctions de référence (60a) représente une machine synchrone comme machine polyphasée.

7. Procédé selon la revendication 1, dans lequel on effectue la répétition selon la caractéristique (e) sur au moins une phase électrique (enroulement) de la machine (1) autre que les étapes (b) à (d) pour obtenir la première valeur de mesure (r1).

8. Procédé selon la revendication 1, dans lequel le convertisseur présente une partie de commande (11) et une partie de puissance (10).

9. Procédé selon la revendication 1, dans lequel le convertisseur est un dispositif de puissance, qui délivre des signaux de réglage de puissance sur plusieurs phases de sortie électriques (n, 4) et qui obtient les signaux de réglage d'un circuit intermédiaire qui est alimenté par un redresseur à partir d'un réseau (9, N).

10. Procédé selon la revendication 1, dans lequel la fonction de comparaison (60, 50) et la au moins une fonction de référence (50a, 60a) reproduisent la même grandeur physique sous la forme d'une série de valeurs de mesure (r1, r2) sur la même grandeur de système (α).

11. Procédé selon la revendication 10, dans lequel la grandeur physique est une résistance ou une impédance (Z) s'étendant sur un angle de stator ou un angle de champ de stator (α) de la machine polyphasée connectée.

12. Procédé selon la revendication 10, dans lequel une courbe de la grandeur physique sous la forme d'une série de valeurs de mesure dans la fonction de référence (50a, 50b) se déroule de manière sensiblement constante sur un angle de stator (α).

13. Procédé selon la revendication 10 ou 12, dans lequel au moins une fonction de référence (50a, 50b) ne présente pas de maximum prononcé et pas de minimum prononcé.

14. Procédé selon la revendication 10, dans lequel une courbe de la grandeur physique d'au moins une fonction de référence présente au moins un minimum prononcé et au moins un maximum prononcé (60a, 60b).

15. Procédé selon la revendication 11, dans lequel au moins le nombre prépondérant des valeurs de résistance ou d'impédance (r1, r2, ...) mesurées et déterminées comme valeurs de mesure appliquées en fonction de l'angle de stator (α) se situent à l'intérieur d'une bande (b) qui est formée de pas plus de sensiblement ± 20 % d'une valeur moyenne, que l'on obtient à partir des valeurs de mesure, en particulier à l'intérieur d'une bande dans les ±10 % de la valeur moyenne.

16. Procédé selon l'une quelconque des revendications précédentes 11 à 15, dans lequel la grandeur de mesure de la conséquence causale mesurée du premier signal d'essai est une grandeur physique autre que l'impédance ou la résistance.

17. Procédé selon la revendication 1 ou 10, dans lequel on exploite de multiples résultats de mesure et on les affecte à la fonction de comparaison sous la forme de multiples valeurs de mesure (50, 60), dans lequel l'exploitation contient un calcul pour déterminer une valeur de mesure à partir du résultat de mesure, par exemple un calcul de résistance ou d'impédance à partir d'une mesure de courant.

18. Procédé selon la revendication 1, dans lequel les multiples programmes de système (12a, 12b, 12c) représentent de multiples types de machines polyphasées (1), en particulier comme partie de programme de réglage, comme partie de programme de commande ou comme partie de programme de surveillance.

19. Procédé selon la revendication 1, dans lequel ladite au moins une conséquence causale représente une ou plusieurs des caractéristiques parmi le courant, la tension, la vitesse de rotation ou le changement de position.

20. Procédé selon la revendication 1, dans lequel ledit au moins un premier signal d'essai est un signal alterné stationnaire, un signal d'impulsion ou un bref signal alterné de fréquence.

21. Procédé selon la revendication 20, dans lequel le signal alterné possède une fréquence d'au moins 10 Hz, en particulier un multiple de cette fréquence, pour ne pas modifier sensiblement la position de rotation (ϕ) d'un rotor de la machine polyphasée, tandis que le signal alterné s'applique aux phases électriques ou aux enroulements de la machine polyphasée (1).

22. Procédé selon la revendication 1, 2 ou 20, dans lequel un signal d'essai respectif est simultanément appliqué sur les multiples phases et est un signal d'essai polyphasé respectif.

23. Procédé selon la revendication 20 ou 21, dans lequel le premier signal d'essai possède une fréquence supérieure à sensiblement 100 Hz.

24. Procédé selon la revendication 1, 20 ou 23, dans lequel un signal de base alterné inférieur à sensiblement 10 Hz comme grandeur de réglage polyphasée fait tourner le rotor (1b) de la machine polyphasée (1) lentement dans sa position de rotation (ϕ) et plusieurs signaux d'essai sont modulés sur la grandeur de réglage polyphasée dans un intervalle temporel.

25. Procédé selon la revendication 1 ou 20, dans lequel le rotor (1b) de la machine polyphasée se déplace avec un signal de réglage en plusieurs positions du rotor (ϕ1, ϕ2) non identiques, c'est-à-dire différentes, pour commuter, dans une position de rotation respective, en permanence un signal d'essai respectif sur les phases électriques et mesurer la conséquence causale respective pour l'exploitation en plusieurs valeurs de mesure pour la fonction de comparaison (50, 60).

26. Procédé selon la revendication 25, dans lequel on lance une pluralité de positions de rotor (ϕ), en particulier plus de 50 positions de rotation de la machine polyphasée et on les mesure en matière de conséquence causale respective dans un signal d'essai respectif.

27. Procédé selon la revendication 1, dans lequel les étapes (b) à (d) sont répétées pour un autre signal d'essai afin d'obtenir une autre valeur de mesure (r2).

28. Procédé selon la revendication 27, dans lequel la répétition se fait à plusieurs reprises jusqu'à ce qu'il se forme une fonction de comparaison (50, 60) pourvue de multiples valeurs de mesure, qui est comparée à ladite au moins une fonction de référence (60a, 60b, 50a, 50b) selon la caractéristique (e) de la revendication 1.

29. Procédé selon la revendication 27 ou 28, dans lequel chaque signal d'essai polyphasé autre que le deuxième, le troisième, etc. signal d'essai est un signal polyphasé pour la formation de plusieurs vecteurs de position d'écoulement dans le système de stator (α) de la machine (1), lesquels vecteurs sont positionnés dans différentes positions angulaires (α1, α2, α3) du stator, tandis que le rotor (1b) ne se déplace pratiquement pas.
